# FASCICULE DE BREVET EUROPEEN

(11) **EP 0 496 666 B1**
(45) Date de publication et mention de la délivrance du brevet: **20.03.1996**
(21) Numéro de dépôt: 92400153.0
(22) Date de dépôt: 21.01.1992
(51) Int. Cl.: H01L 39/24, H01L 39/14

(54) **Procédé d'assemblage de billettes composites pour la fabrication de brins supraconducteurs multifilamentaires**
Verfahren zum Assemblieren zusammengesetzter Stränge zur Herstellung von multifilamentären supraleitenden Drähten
Procedure of assembling composite billets for manufacturing of multifilamentary superconducting wires

(30) Priorité: 24.01.1991 FR 9100795
(43) Date de publication de la demande: 29.07.1992
(73) Titulaire: ALSTHOM INTERMAGNETICS SA, F-90018 Belfort Cédex (FR)
(72) Inventeur: Peltier, François, F-90350 Evette-Salbert (FR); Hoang, Gia Ky, F-90300 Cravanche (FR); Sulten, Philippe, F-90350 Evette-Salbert (FR); Grunblatt, Gérard, F-70400 Errevet (FR)
(74) Mandataire: Vigand, Privat

(56) Documents cités:
- EP-A- 0 054 421
- WO-A-92/01316
- IEEE TRANSACTIONS ON MAGNETICS, vol.25, no.2, March 1989, pages 2105-2108, New York, US & APPLIED SUPERCONDUCTIVITY CONFERENCE, August 1988, San Francisco, US; Ohmatsu, K. et al: "AC losses of NbTi superconducting wires with fine filament."

## Description

La présente invention a pour objet un procédé d'assemblage de billettes composites pour la fabrication de brins supraconducteurs multifilamentaires et notamment de fils supraconducteurs à base d'alliages métalliques (NbTi, Nb₃ Sn...) ainsi que de tout autre composite à renforcement fibreux.

Le procédé conventionnel de fabrication de fils supraconducteurs comporte une ou plusieurs extrusions à chaud des billettes composites suivies d'étirage et de tréfilage jusqu'au diamètre final. Ces billettes sont généralement constituées d'un corps cylindrique qui contient selon les cas, quelques centaines à quelques dizaines de milliers de composants présentées sous forme de tiges qui pourront être elles-mêmes composites.

La réduction du nombre d'extrusions est une des voies possibles à suivre, afin de réduire les coûts de fabrication, et en même temps d'améliorer les performances du brin supraconducteur. Une telle réduction serait possible si l'on pouvait fabriquer des billettes comportant un nombre important de tiges. Mais la confection de telles billettes présente des difficultés d'ordre pratique qui croissent avec le nombre de composants :
- Avec les tiges de section hexagonale (EP-A-0054 421), habituellement utilisées pour assurer un bon remplissage, le temps nécessaire pour l'empilement est long en supposant que les tiges sont bien dressées et non vrillées. Le nombre de tiges hexagonales assemblables de façon correcte reste très limité sans outillage adéquat.
- L'utilisation des tiges de section circulaire permet une réduction du temps d'empilement mais conduit à un mauvais taux de remplissage, qui est dû aux nombreux croisements des tiges et à l'existence des espaces vides entre ces dernières.

Le procédé selon l'invention est caractérisé en ce qu'on empile dans le corps cylindrique des barres d'outillage possédant un axe longitudinal de symétrie d'ordre n (nombre entier positif supérieur ou égal à 2), puis on enlève ces barres en remplaçant chaque barre à mesure qu'on l'enlève par un barreau constitué de tiges élémentaires empilées de manière ordonnée et compacte pour avoir un encombrement minimum, chaque barreau ayant la même section que la barre qu'il remplace.

Le temps d'assemblage est notablement plus court qu'avec la méthode classique et les billettes obtenus sont très compactes.

Selon une réalisation préférentielle de l'invention permettant un assemblage très rapide et très compact, le procédé est caractérisé en ce que les barres d'outillages sont de section rectangulaire et en ce que chaque barreau de même section que la barre qu'il remplace est constitué d'un empilement de tiges élémentaires de section rectangulaire ou de préférence carrée.

Les barres ont de préférence des sections rectangulaires ou carrées de grosseurs différentes pour accroître encore la rapidité de l'assemblage.

L'invention va maintenant être décrite plus en détail en se référant à deux modes de réalisation particulier à titre d'exemples non limitatifs illustrés par des dessins annexés.

La figure 1 représente une billette en cours d'assemblage.

La figure 2 représente les barreaux de tiges utilisés pour l'assemblage de la figure 1.

La figure 3 représente une variante de billette en cours d'assemblage.

La figure 4 représente un barreau pour l'assemblage de la figure 3.

Selon le procédé de l'invention, on remplit le corps 1 de la billette 2 qui est un cylindre en cuivre ou en cupro-nickel disposé horizontalement avec des barres 3, 4, 5 de section carrée. Ces barres 3, 4, 5 ont des sections différentes. La barre 3 qui est la barre grosse a une section égale à 144 fois (12X12) la section d'une tige élémentaire 6 de section carrée.

La barre 4 moyenne a une section égale à 6X6 fois la section d'une tige 6 et la barre petite 5 a une section égale à 3X3 fois la section d'une tige 6.

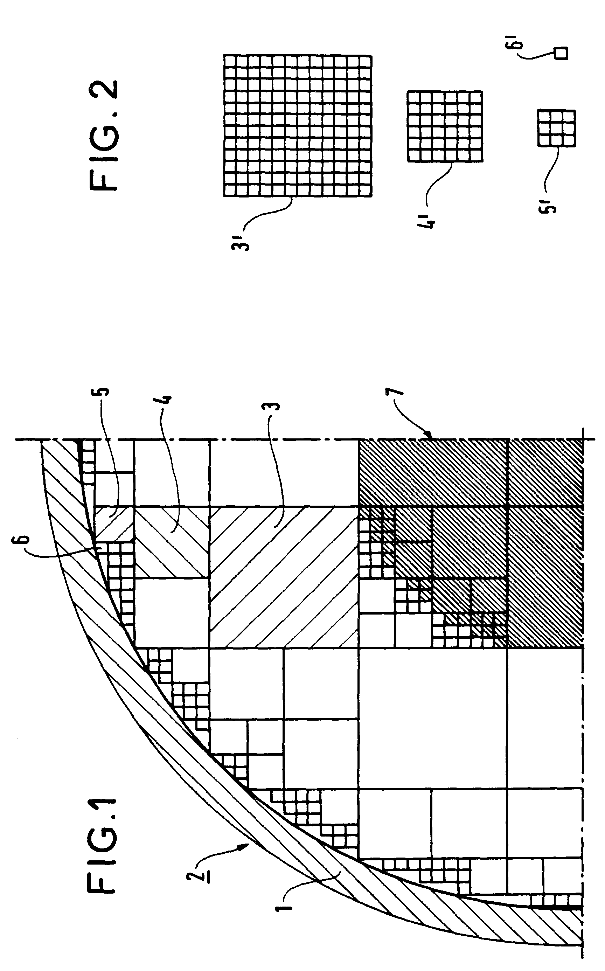

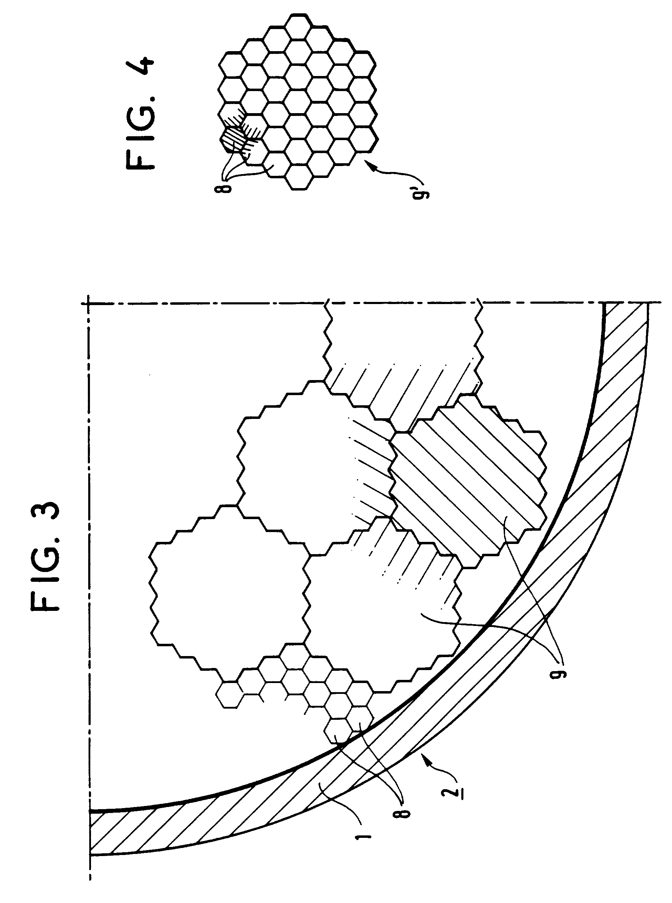

Ensuite on emplit les espaces restant avec des tiges élémentaires 6 notamment le long de la surface interne de corps 1 (voir figure 1).

On retire alors les barres 3, 4, 5 une à une en remplacant chaque barre à mesure qu'on la retire par un barreau de même section.

Le barreau 3′ remplacant la barre 3 a été réalisé par l'empilement de 144 tiges élémentaires 6, le barreau 4′ a été réalisé par l'empilement de 36 tiges et le barreau 5′ par l'empilement de 9 tiges. (voir figure 2).

Ainsi dans l'exemple décrit la billette doit comporter 1092 tiges de cuivre au centre entourées de 3876 tiges composite chaque tige ayant une section de 2,2X2,2 mm.

On aura donc disposé au centre une grosse barre 3 entourée de quatre barres 3, avec des barres 4 et 5 pour remplir l'espace intermédiaire entre les quatre grosses barres 3 de façon à former un assemblage 7 au centre dont la section se rapproche d'un cercle.

Les barres de cet assemblage 7 vont être remplacées une à une par des barreaux correspondant constitués de tiges élémentaires en cuivre. Les barres autour de cet assemblage 7 seront remplacées par des barreaux correspondants constitués de tiges composites. A la limite de cet assemblage 7, certaines barres seront remplacées par des barreaux mixtes ayant des tiges en cuivre et des tiges composites. Dans tous les cas l'empilement de type carré selon l'invention permet le maintien des tiges 6 déjà placées dans leur position définitive même pendant l'opération de substitution.

Bien que l'exemple décrit, on utilise des tiges 6, des barres 3, 4, 5 et des barreaux 3′, 4′, 5′ de sections carrées, on pourrait, bien que cela rende la fabrication un peu plus longue, utiliser des tiges et/ou des barres et des barreaux de sections rectangulaires pour les uns et de sections carrées pour d'autres ou bien tous de sections rectangulaires.

Plus généralement, le procédé selon l'invention, est applicable à toute billette constituée de tiges de section polygonale à condition que la forme des barres d'outillage utilisées soit celle d'un barreau obtenu par l'empilement ordonné et compact des tiges élémentaires.

Cet empilement doit être fait de manière que la section du barreau ait un encombrement minimum et possède un axe longitudinal de symétrie de rotation d'ordre n, n étant un entier positif égal ou supérieur à 2. L'exemple montré dans les figures 3 et 4 correspond au cas des tiges de section hexagonale 8 avec des barres d'outillage 9 qui ont la forme d'un barreau 9′de 37 tiges élémentaires 8 obtenu par un empilement hexagonal.

## Revendications

1. Procédé d'assemblage de billettes composites (2) à section circulaire pour la fabrication de brins supraconducteurs multifilamentaires dans lequel on remplit un corps cylindrique (1) avec des tiges polygonales élémentaires (6, 8) à base d'alliages métalliques ou en métal,
caractérisé en ce qu'on empile dans le corps cylindrique (1) des barres d'outillage (3, 4, 5, 9) possédant un axe longitudinal de symétrie d'ordre n, n étant un nombre entier positif supérieur ou égal à 2, puis on enlève ces barres (3, 4, 5, 9) en remplaçant chaque barre par un barreau constitué de tiges élémentaires (6, 8) empilées de manière ordonnée et compacte pour avoir un encombrement minimum, chaque barreau (3', 4', 5', 9') ayant la même section que la barre (3, 4, 5, 9) qu'il remplace.

2. Procédé selon la revendication 1, caractérisé en ce que les barres d'outillages sont de section rectangulaire et en ce que chaque barreau de même section que la barre qu'il remplace est constitué d'un empilement de tiges élémentaires (6) de section rectangulaire ou de préférence carrée.

3. Procédé selon la revendication 2, caractérisé en ce que les barres d'outillages (3, 4, 5) sont de section carrée ainsi que les barreaux (3', 4', 5') qui les remplacent.

4. Procédé selon l'une des revendications 2 ou 3, caractérisé en ce que les barres d'outillages (3, 4, 5) ont des sections de grosseur différente.

## Patentansprüche

1. Verfahren zum Zusammenbau von Verbundbarren (2) mit Kreisquerschnitt für die Herstellung von vieladrigen Supraleitern, wobei man einen zylindrischen Körper (1) mit elementaren Stäben polygonalen Querschnitts (6, 8) auf der Basis einer Metallegierung oder eines Metalls füllt, dadurch gekennzeichnet, daß man im zylindrischen Körper (1) Montagehilfsstäbe (3, 4, 5, 9) stapelt, die eine Längssymmetrieachse der Ordnung n besitzen, wobei n eine positive ganze Zahl größer oder gleich 2 ist, daß dann diese Montagehilfsstäbe (3, 4, 5, 9) nacheinander entnommen und je durch ein Bündel von Elementarstäben (6, 8) ersetzt werden, die geordnet kompakt mit minimalem Raumbedarf gestapelt sind, wobei jedes Bündel (3', 4', 5', 9') den gleichen Querschnitt wie der von ihm ersetzte Montagehilfsstab (3, 4, 5, 9) hat.

2. Verfahren nach Anspruch 1, dadurch gekennzeichnet, daß die Montagehilfsstäbe einen Rechteckquerschnitt besitzen und daß jedes Bündel gleichen Querschnitts wie der von ihm ersetzte Montagehilfsstab aus der Stapelung von Elementarstäben (6) mit Rechteckquerschnitt und vorzugsweise quadratischem Querschnitt gebildet wird.

3. Verfahren nach Anspruch 1, dadurch gekennzeichnet, daß die Montagehilfsstäbe (3, 4, 5) ebenso wie die sie ersetzenden Bündel (3', 4', 5') einen quadratischen Querschnitt besitzen.

4. Verfahren nach einem der Ansprüche 2 oder 3, dadurch gekennzeichnet, daß die Montagehilfsstäbe (3, 4, 5) Querschnitte unterschiedlicher Größe besitzen.

## Claims

1. A method of assembling composite billets (2) of circular section for manufacturing multifilament superconducting strands, in which a cylindrical body (1) is filled with unit polygonal rods (6, 8) based on metal or on metal alloy, the method being characterized in that jig bars (3, 4, 5, 9) having a longitudinal axis of symmetry of order n, where n is a positive integer greater than or equal to two, are stacked inside the cylindrical body (1), after which the jig bars (3, 4, 5, 9) are removed with each jig bar being replaced by a multi-part bar made up of unit rods (6, 8) stacked in ordered and compact manner to occupy minimum space, each multi-part bar (3', 4', 5', 9') having the same section as the jig bar (3, 4, 5, 9) that it replaces.

2. A method according to claim 1, characterized in that the jig bars are rectangular in section and in that each multi-part bar having the same section as the jig bar it replaces is constituted by a stack of unit rods (6) that are rectangular in section, or are preferably square in section.

3. A method according to claim 2, characterized in that the jig bars (3, 4, 5) are square in section as are the multi-part bars (3', 4', 5') that replace them.

4. A method according to claim 2 or 3, characterized in that the jig bars (3, 4, 5) have sections of different sizes.
